# EUROPEAN PATENT SPECIFICATION

(11) **EP 1 640 337 B1**
(45) Date of publication and mention of the grant of the patent: **28.10.2009**
(21) Application number: 05255679.2
(22) Date of filing: 14.09.2005
(51) Int. Cl.: G02B 26/00, G02F 1/1333

(54) **Apparatus and methods for arranging micromechanical devices into an interconnected array**
Vorrichtung und Verfahren, um mikromechanische Bauteile zu einer untereinander verbundenen Matrix anzuordnen
Dispositif et méthode d'assembler des éléments micromécaniques dans une matrice interconnecté

(30) Priority: 27.09.2004 US 613487 P; 11.03.2005 US 78025
(43) Date of publication of application: 29.03.2006
(73) Proprietor: IDC, LLC, San Francisco, CA 94107 (US)
(72) Inventor: Kothari, Manish, Cupertino, California 95014 (US)
(74) Representative: Dunlop, Hugh Christopher

(56) References cited:
- WO-A-99/41732
- US-A- 5 777 705
- US-A- 5 875 011
- US-A1- 2002 075 555
- US-A1- 2003 054 588
- US-B1- 6 262 696
- ARATANI K ET AL: "SURFACE MICROMACHINED TUNEABLE INTERFEROMETER ARRAY" SENSORS AND ACTUATORS A, ELSEVIER SEQUOIA S.A., LAUSANNE, CH, vol. A43, no. 1/3, 1 May 1994 (1994-05-01), pages 17-23, XP000454081 ISSN: 0924-4247

## Description

### Background

The field of the invention relates to apparatus and methods for arranging devices into an interconnected array. More specifically, the invention relates to an array of interferometric modulator devices that have a minimized ledge area between each device to produce a large format image.

Display devices can be attached to each other by tiling which involves placing multiple display devices adjacent one another to create one larger system. Tiling is particularly useful for building larger displays and can be used when the largest producible display is smaller than the display size that is desired. For example, a billboard or other signage is typically too large to produce from a single piece of glass. In addition, the price to produce a large piece of glass can be quite high. Thus, tiling can be used as a low cost alternative by creating a large display from a number of smaller displays.

Once complete, the tiled display can be used substantially like that of a large display. For example, it can produce a single full image. Because it is tiled, the array has the additional advantage of allowing a separation of the images when desired to produce different discreet images on what appears to be a single display screen.

Generally, when tiling display devices into an array, there is a gap area between the display area of one device and the display area of adjacent devices. This gap area limits the image quality of the larger display when the gap area is discernible to the viewer.

US-A-5 777 705 describes a plurality of liquid crystal display (LCD) tiles, arranged in a matrix, that are electrically interconnected to a single tile carrier, comprising top and bottom cover plates, by wire bonds. Each LCD tile comprises two optically clear glass plates, one of which has a projecting ledge for bonding. The LCD tile is bonded to an interior surface of the bottom cover plate by an adhesive layer, and a wire is bonded between a circuit path on the projecting ledge and a conductive pad on the bottom cover plate of the carrier. The conductive pad connects to electrical circuitry to provide for electrical connection to an external circuit board or card.

US-A-2002/075555 describes an interferometric modulator device comprising an interference cavity for causing interference modulation of light, the cavity having a mirror comprising a corrugated surface. The interferometric modulator may be used in a display device.

Sensors and Actuators A, Elsevier Sequoia S.A., Lausanne, CH, Vol. A43, No. 1/3, 1 May 1994, pages 17 to 23, Aratani K. et al Entitled "Surface Micromachined Tunable Interferometer Array" describes the development of compact light modulators.

WO-A-99/41732 discloses a tiled display device formed from OLED display tiles having pixel elements positioned to the edge of each of the tiles.

### Summary

One embodiment of the invention is in array of device as defined in claim 5.

Another embodiment of the invention is a method of manufacturing an array of display devices as defined in claim 1.

### Brief Description of the Drawings

Figure 1 is an isometric view depicting a portion of one embodiment of an interferometric modulator display in which a movable reflective layer of a first interferometric modulator is in a released position and a movable reflective layer of a second interferometric modulator is in an actuated position.
Figure 2 is a system block diagram illustrating one example of an electronic device incorporating a 3x3 interferometric modulator display.
Figure 3 is a diagram of movable mirror position versus applied voltage for one example of an interferometric modulator of Figure 1.
Figure 4 is an illustration of a set of row and column voltages that may be used to drive an interferometric modulator display.
Figure 5A illustrates one exemplary frame of display data in the 3x3 interferometric modulator display of Figure 2.
Figure 5B illustrates one exemplary timing diagram for row and column signals that may be used to write the frame of Figure 5A.
Figure 6A is a cross section of the device of Figure 1.
Figure 6B is a cross section of an embodiment of an interferometric modulator.
Figure 6C is a cross section of another embodiment of an interferometric modulator.
Figure 7 is a cross section of a basic package structure for a MEMS device.
Figure 8 is an exploded view of an embodiment of a display in which a printed circuit carrier is bonded to a backplate.
Figure 9 is an exemplary embodiment of a reduced footprint display device.
Figure 10 is an exploded view of an exemplary embodiment of a reduced footprint display device.
Figures 11A and 11B are diagrams showing embodiments of tiling of the displays.
Figures 12A and 12B are system block diagrams illustrating an embodiment of a visual display device comprising a plurality of interferometric modulators.

### Detailed Description of the Preferred Embodiments

One embodiment of the invention is a large format display that is made up of a plurality of individual display devices. The individual display devices are placed adjacent one another, in a process known as tiling, so that they from one large display. In this embodiment, the edges between each individual display devices are minimized so that the edges are not visible to the viewer when looking at the large format display.

The following detailed description is directed to certain specific embodiments of the invention. In this description, reference is made to the drawings wherein like parts are designated with like numerals throughout. As will be apparent from the following description, the invention may be implemented in any device that is configured to display an image, whether in motion (e.g., video) or stationary (e.g., still image), and whether textual or pictorial. More particularly, it is contemplated that the invention may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e.g., display of images on a piece of jewelry). MEMS devices of similar structure to those described herein can also be used in non-display applications such as in electronic switching devices.

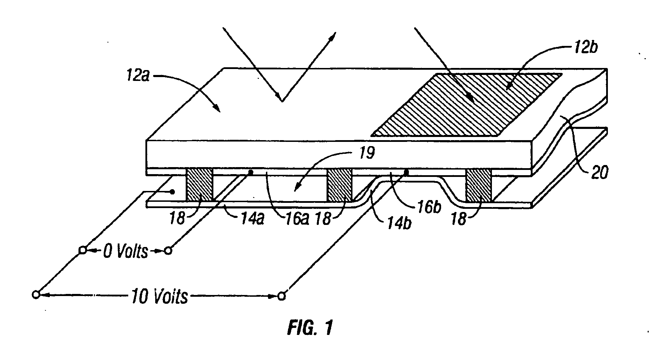

One interferometric modulator display comprising an interferometric MEMS display element is illustrated in Figure 1. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the realisation, the light reflectance properties of the "on" and "off" states may be reversed. MEMS pixels can be configured to reflect predominantly at selected colors, allowing for a color display in addition to black and white.

Figure 1 is an isometric view depicting two adjacent pixels in a series of pixels of a visual display, wherein each pixel comprises a MEMS interferometric modulator. In some cases, an interferometric modulator display comprises a row/column array of these interferometric modulators. Each interferometric modulator includes a pair of reflective layers positioned at a variable and controllable distance from each other to form a resonant optical cavity with at least one variable dimension. In one example, one of the reflective layers may be moved between two positions. In the first position, referred to herein as the released state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 1 includes two adjacent interferometric modulators 12a and 12b. In the interferometric modulator 12a on the left, a movable and highly reflective layer 14a is illustrated in a released position at a predetermined distance from a fixed partially reflective layer 16a. In the interferometric modulator 12b on the right, the movable highly reflective layer 14b is illustrated in an actuated position adjacent to the fixed partially reflective layer 16b.

The fixed layers 16a, 16b are electrically conductive, partially transparent and partially reflective, and may be fabricated, for example, by depositing one or more layers each of chromium and indium-tin-oxide onto a transparent substrate 20. The layers are patterned into parallel strips, and may form row electrodes in a display device as described further below. The movable layers 14a, 14b may be formed as a series of parallel strips of a deposited metal layer or layers (orthogonal to the row electrodes 16a, 16b) deposited on top of posts 18 and an intervening sacrificial material deposited between the posts 18. When the sacrificial material is etched away, the deformable metal layers are separated from the fixed metal layers by a defined air gap 19. A highly conductive and reflective material such as aluminum may be used for the deformable layers, and these strips may form column electrodes in a display device.

With no applied voltage, the cavity 19 remains between the layers 14a, 16a and the deformable layer is in a mechanically relaxed state as illustrated by the pixel 12a in Figure 1. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the pixel 12b on the right in Figure 1. The behavior is the same regardless of the polarity of the applied potential difference. In this way, row/column actuation that can control the reflective vs. non-reflective pixel states is analogous in many ways to that used in conventional LCD and other display technologies.

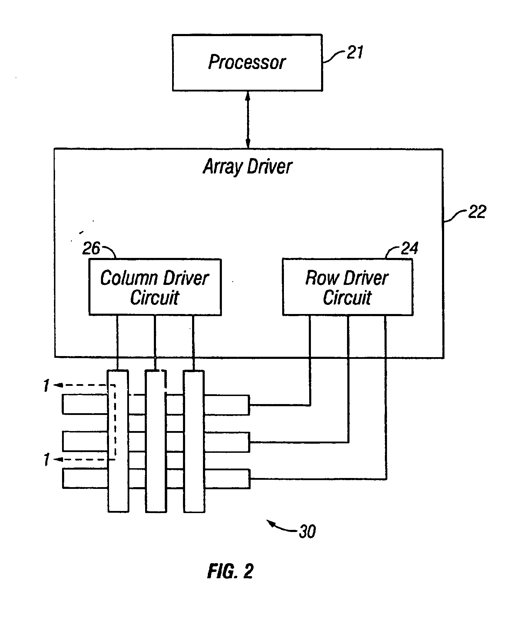

Figures 2 through 5B illustrate one exemplary process and system for using an array of interferometric modulators in a display application. Figure 2 is a system block diagram illustrating one example of an electronic device . In the example, the electronic device includes a processor 21 which may be any general purpose single- or multi-chip microprocessor such as an ARM, Pentium®, Pentium II®, Pentium III®, Pentium IV®, Pentium® Pro, an 8051, a MIPS®, a Power PC®, an ALPHA®, or any special purpose microprocessor such as a digital signal processor, microcontroller, or a programmable gate array. As is conventional in the art, the processor 21 may be configured to execute one or more software modules. In addition to executing an operating system, the processor may be configured to execute one or more software applications, including a web browser, a telephone application, an email program, or any other software application.

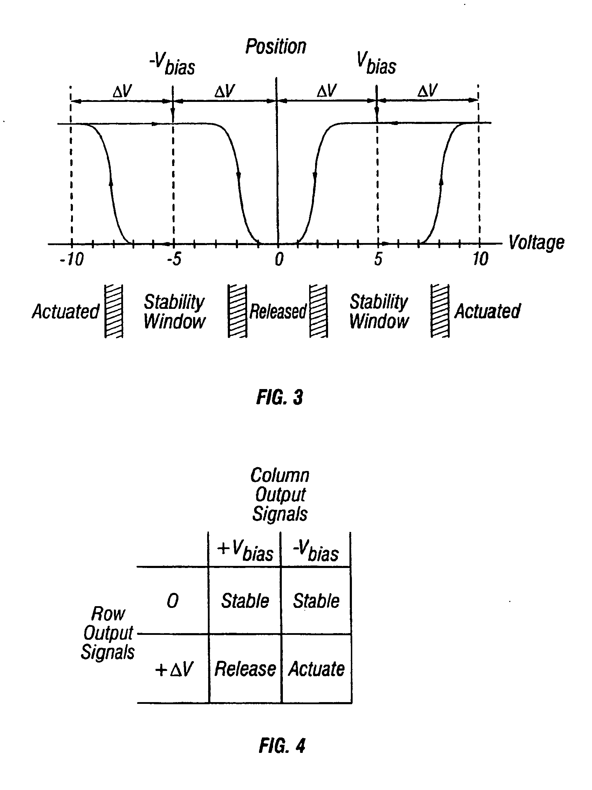

In one example, the processor 21 is also configured to communicate with an array controller 22. In one example, the array controller 22 includes a row driver circuit 24 and a column driver circuit 26 that provide signals to a pixel array 30. The cross section of the array illustrated in Figure 1 is shown by the lines 1-1 in Figure 2. For MEMS interferometric modulators, the row/column actuation protocol may take advantage of a hysteresis property of these devices illustrated in Figure 3. It may require, for example, a 10 volt potential difference to cause a movable layer to deform from the released state to the actuated state. However, when the voltage is reduced from that value, the movable layer maintains its state as the voltage drops back below 10 volts. In the example of Figure 3, the movable layer does not release completely until the voltage drops below 2 volts. There is thus a range of voltage, about 3 to 7 V in the example illustrated in Figure 3, where there exists a window of applied voltage within which the device is stable in either the released or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be released are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 1 stable under the same applied voltage conditions in either an actuated or released pre-existing state. Since each pixel of the interferometric modulator, whether in the actuated or released state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

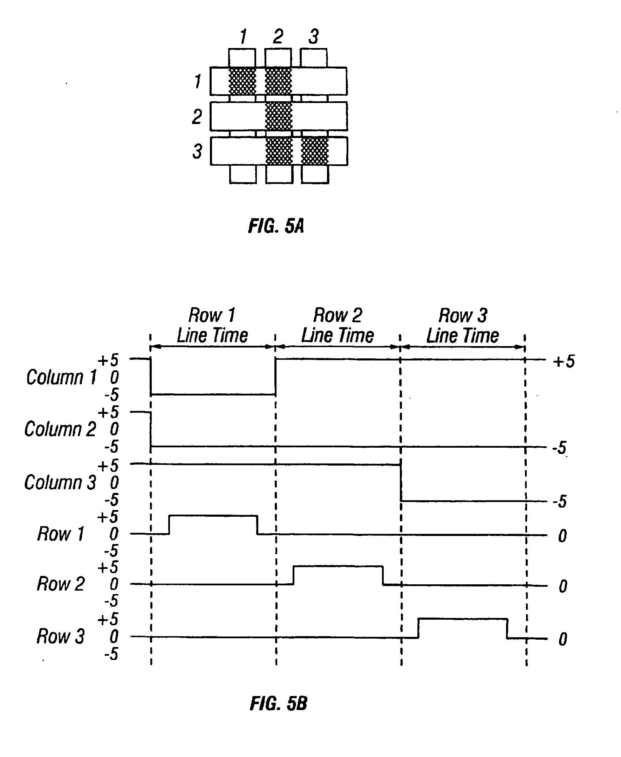

Figures 4, 5A, and 5B illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to ―Vbias, and the appropriate row to +ΔV, which may correspond to -5 volts and +5 volts respectively Releasing the pixel is accomplished by setting the appropriate column to +Vbias, and the appropriate row to the same +ΔV, producing a zero volt potential difference across the pixel. In those rows where the row voltage is held at zero volts, the pixels are stable in whatever state they were originally in, regardless of whether the column is at +Vbias, or -Vbias.

Figure 5B is a timing diagram showing a series of row and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or released states.

In the Figure 5A frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and releases the (1,3) pixel. No other pixels in the array are affected. To set row 2 as desired, column 2 is set to -5 volts, and columns 1 and 3 are set to +5 volts. The same strobe applied to row 2 will then actuate pixel (2,2) and release pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention.

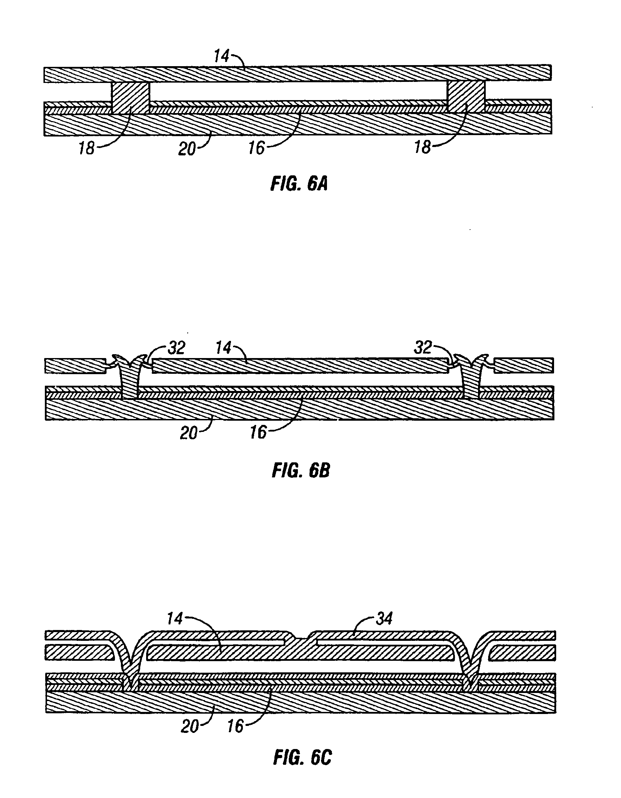

The details of the structure of interferometric modulators that operate in accordance with the principles set forth above may vary widely. For example, Figures 6A-6C illustrate three different examples of the moving mirror structure. Figure 6A is a cross section of the example of Figure 1, where a strip of metal material 14 is deposited on orthogonally extending supports 18. In Figure 6B, the moveable reflective material 14 is attached to supports at the corners only, on tethers 32. In Figure 6C, the moveable reflective material 14 is suspended from a deformable layer 34. This example has benefits because the structural design and materials used for the reflective material 14 can be optimized with respect to the optical properties, and the structural design and materials used for the deformable layer 34 can be optimized with respect to desired mechanical properties. The production of various types of interferometric devices is described in a variety of published documents, including, for example, U.S. Published Application 2004/0051929. A wide variety of well known techniques may be used to produce the above described structures involving a series of material deposition, patterning, and etching steps.

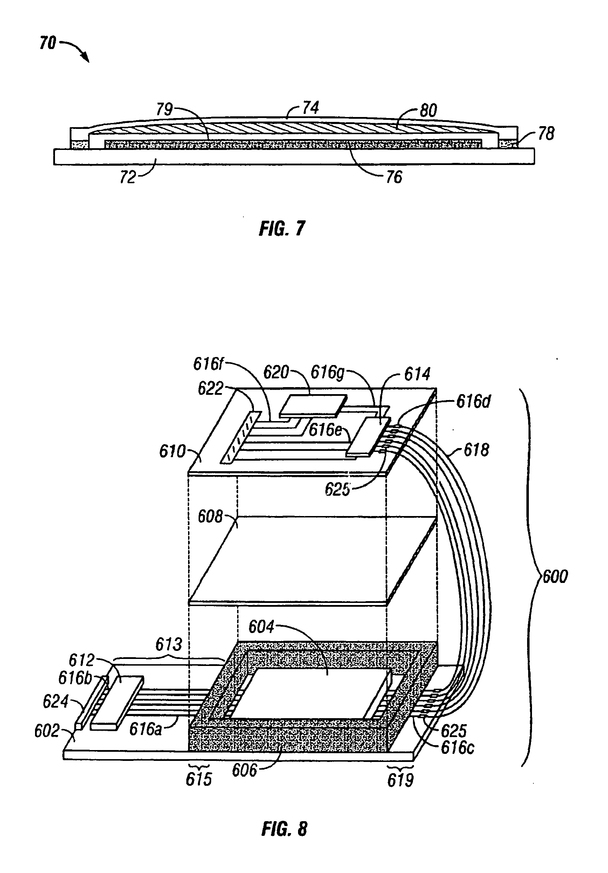

The moving parts of a MEMS device, such as an interferometric modulator array, preferably have a protected space in which to move. Packaging techniques for a MEMS device will be described in more detail below. A schematic of a basic package structure for a MEMS device, such as an interferometric modulator array, is illustrated in Figure 7. As shown in Figure 7, a basic package structure 70 includes a substrate 72 and a backplane cover or "cap" 74, wherein an interferometric modulator array 76 is formed on the substrate 72. This cap 74 is also called a "backplate".

The substrate 72 and the backplane 74 are joined by a seal 78 to form the package structure 70, such that the interferometric modulator array 76 is encapsulated by the substrate 72, backplane 74, and the seal 78. This forms a cavity 79 between the backplane 74 and the substrate 72. The seal 78 may be a non-hermetic seal, such as a conventional epoxy-based adhesive. In other realisations, the seal 78 may be a polyisobutylene (sometimes called butyl rubber, and other times PIB), o-rings, polyurethane, thin film metal weld, liquid spin-on glass, solder, polymers, or plastics, among other types of seals that may have a range of permeability of water vapor of about 0.2 ― 4.7 g mm/m2kPa day. In still other embodiments, the seal 78 may be a hermetic seal.

In some examples, the package structure 70 includes a desiccant 80 configured to reduce moisture within the cavity 79. The skilled artisan will appreciate that a desiccant may not be necessary for a hermetically sealed package, but may be desirable to control moisture resident within the package. In one example, the desiccant 80 is positioned between the interferometric modulator array 76 and the backplane 74. Desiccants may be used for packages that have either hermetic or non-hermetic seals. In packages having a hermetic seal, desiccants are typically used to control moisture resident within the interior of the package. In packages having a non-hermetic seal, a desiccant may be used to control moisture moving into the package from the environment. Generally, any substance that can trap moisture while not interfering with the optical properties of the interferometric modulator array may be used as the desiccant 80. Suitable desiccant materials include, but are not limited to, zeolites, molecular sieves, surface adsorbents, bulk adsorbents, and chemical reactants.

The desiccant 80 may be in different forms, shapes, and sizes. In addition to being in solid form, the desiccant 80 may alternatively be in powder form. These powders may be inserted directly into the package or they may be mixed with an adhesive for application. In an alternative example, the desiccant 80 may be formed into different shapes, such as cylinders or sheets, before being applied inside the package.

The skilled artisan will understand that the desiccant 80 can be applied in different ways. In one example, the desiccant 80 is deposited as part of the interferometric modulator array 76. In another example, the desiccant 80 is applied inside the package 70 as a spray or a dip coat.

The substrate 72 may be a semi-transparent or transparent substance capable of having thin film, MEMS devices built upon it. Such transparent substances include, but are not limited to, glass, plastic, and transparent polymers. The interferometric modulator array 76 may comprise membrane modulators or modulators of the separable type. The skilled artisan will appreciate that the backplane 74 may be formed of any suitable material, such as glass, metal, foil, polymer, plastic, ceramic, or semiconductor materials (e.g., silicon).

The packaging process may be accomplished in a vacuum, pressure between a vacuum up to and including ambient pressure, or pressure higher than ambient pressure. The packaging process may also be accomplished in an environment of varied and controlled high or low pressure during the sealing process. There may be advantages to packaging the interferometric modulator array 76 in a completely dry environment, but it is not necessary. Similarly, the packaging environment may be of an inert gas at ambient conditions. Packaging at ambient conditions allows for a lower cost process and more potential for versatility in equipment choice because the device may be transported through ambient conditions without affecting the operation of the device.

Generally, it is desirable to minimize the permeation of water vapor into the package structure and thus control the environment inside the package structure 70 and hermetically seal it to ensure that the environment remains constant. An example of a hermetic sealing process is disclosed in U.S. Patent No. 6,589,625, the entirety of which is hereby incorporated by reference. When the humidity within the package exceeds a level beyond which surface tension from the moisture becomes higher than the restoration force of a movable element (not shown) in the interferometric modulator array 70, the movable element may become permanently stuck to the surface. If the humidity level is too low, the moisture charges up to the same polarity as the movable element when the element comes into contact with the coated surface.

As noted above, a desiccant may be used to control moisture resident within the package structure 70. However, the need for a desiccant can be reduced or eliminated with the implementation of a hermetic seal 78 to prevent moisture from traveling from the atmosphere into the interior of the package structure 70.

The continued reduction in display device dimensions restricts available methods to manage the environment within the package structure 70 because there is less area to place a desiccant 80 within the package structure 70. The elimination of the need for a desiccant also allows the package structure 70 to be thinner, which is desirable in some examples. Typically, in packages containing desiccants, the lifetime expectation of the packaged device may depend on the lifetime of the desiccant. When the desiccant is fully consumed, the interferometric modulator device may fail as sufficient moisture enters the package structure and damages the interferometric modulator array.

As previously stated, the configurations of the examples herein can be suitable for use in display-centric products, such as cell phones, laptop computers, digital cameras, and GPS units. Such devices are display-centric in the sense that each relies on a flat panel display as a primary means of providing information. The display can also participate in input functions. Accordingly, the display can have an impact on the mechanical, electrical, system, and aesthetic design aspects of the product that often exceeds the contributions from the other components in the product. The display is often constructed from a material, such as glass, which tends to be more fragile than the rest of the materials comprising the product. As a result, the mechanical and product design process tends to be centered on the capabilities and characteristics of the display, instead of, e.g., the processor or the battery. Many components within handheld products share similar footprints. These include PC boards, light sources, keyboards, batteries, integrated circuits, supplementary or alternative flat panel displays, and others. Because they are generally planar, the design tools from which they derive produce a similar output, usually in the form of one or more photolithographic masks or other phototools. Thus, there are opportunities for increased integration and increased efficiency in the design process which can be significantly enabled by incorporating functions into the backplate.

Figure 8 depicts an embodiment of an interferometric modulator display device 600, shown in an exploded view. The device 600 includes a transparent substrate 602, which includes an array 604 of interferometric modulators configured to reflect ambient light that has entered through substrate 602. The array 604 provides a means for modulating light and reflecting it towards a viewer. The transparent substrate 602 may comprise a layer of glass. In an alternate embodiment, the transparent substrate 602 may comprise a layer of transparent polymeric material, or any other suitable sufficiently transparent material. The transparent substrate 602 thus provides a means for supporting array 604. In certain embodiments, the transparent substrate 602 can be from about 0.7 to 0.5 millimeters, depending on the nature of the manufacturing process and product.

The device 600 also includes driver chip 612 located on an extended ledge portion 613 of the transparent substrate 602. The extended ledge 613 increases the footprint size of the interferometric modulator display device 600 and thus increases a gap distance between an array of interferometric modulators 604 of any adjacent devices 600. Typically, the extended ledge portion 613 is between 1.5 millimeters and 2.5 millimeters wide and configured for attachment of electrical components such as a driver chip 612. In addition, 1.3 millimeters to 1.5 millimeters of the transparent substrate 602 is occupied by the packaging sealant width 615, further increasing the gap distance between any adjacent array of interferometric modulators.

This gap distance limits the image quality of a larger display comprising an array of display devices 600 that are configured together at adjacent extended ledges 613 since the gap distance between the interferometric modulators 604 of adjacent display devices 600 may be discernible to a viewer. In contrast, the image quality of an array of display devices 600 is not limited by the extended ledge 613 if the extended ledge 613 is not adjacent another display device 600 in the array of display devices 600.

In this embodiment, the driver chip 612 is located on the same side of substrate 602 as array 604, and placed in electrical connection with array 604 through trace leads 616a, to which driver chip 612 is directly bonded. This approach to chip placement is known as chip on glass (COG). The driver chip 612 can be placed in electrical connection with external circuitry (not shown) through trace leads 616b which connect with a mounting point 624 (e.g. for a flex cable or other polymeric film with conductors and insulators or wire bonding). Other chip bonding approaches may be used, including but not limited to chip on flex/foil (COF), tape automated bonding (TAB), or any other flex type bonding.

Located on substrate 602, and surrounding the array 604, is a seal 606, depicted here as an annular seal, under which the trace leads 616a and 616c run. The seal 606 may be referred to as a seal ring, as in various embodiments, the seal 606 completely encircles the array 604. The seal 606 may be a semi-hermetic seal, such as a conventional epoxy-based adhesive. In other embodiments, the seal 606 may be a PIB, o-ring(s), polyurethane, liquid spin-on glass, solder, polymers, or plastics, among other types of seals. In still other embodiments, the seal 606 may be a hermetic seal, such as a thin film metal weld or a glass frit. In one embodiment, the seal 606 is 1.3 to 1.5 millimeters in width.

Still with respect to Figure 8, a backplate 608, together with at least the seal 606 and transparent substrate 602, forms a protective cavity enclosing the array 604 of interferometric modulators. Although not shown, a desiccant may be provided within the protective cavity, in order to prevent moisture buildup over the lifetime of the device. The backplate 608 may be made of any suitable material, whether transparent or opaque, conductive or insulating. Suitable materials for the backplate 608 include, but are not limited to, glass (e.g. float, 1737, soda lime), plastic, ceramics, polymers, laminates, and metals and metal foils (e.g. stainless steel (SS302, SS410), Kovar, plated Kovar). In contrast to an LCD, which would require electrode arrays on both substrates, the array 604 resides on only one substrate, enabling backplate 608 to be made of a material which is thinner and/or completely different from the material used in transparent substrate 602. In one embodiment, the backplate 608 is adapted to prevent moisture from entering the protective cavity and damaging the array 604. Thus, a component such as backplate 608 provides a means for protecting the array 604 from moisture and other environmental contaminants.

The display also includes a printed circuit (PC) carrier 610, located on the opposite side of backplate 608 as the transparent substrate 602. The PC carrier 610 may be a PC carrier/component stack-up for a display product such as a personal digital assistant (PDA) or a cellular phone. The PC carrier 610 may be fabricated separately from the backplate 608, and then bonded to the backplate.

To reduce the footprint of the interferometric modulator display device 600, an alternate placement is shown for a driver chip 614, which is located on the upper side of PC carrier 610, and is in electrical connection with array 604 by means of trace leads 616c,d, bonding pads 625, and an electrical connector 618 (depicted as wire bonding). Since the driver chip 614 is not on the substrate 602, the ledge area 619 may be reduced. By reducing the ledge area 619 of the display device 600, the image quality is improved of a larger display comprising an array of display devices 600 that are configured together by at least one ledge 619. This improvement of image quality comes from a reduction in the gap distance between the interferometric modulators 604 of adjacent display devices in the array.

The reduced ledge portion 619 of the transparent substrate 602 comprises an electrical connection area comprising bonding pads 625 (e.g. for wire bonds) that connects to trace leads 616c. In exemplary embodiments, the use of wire bonding as the electrical connector 618 allows for a reduced ledge area 619 of less than or equal to 1 mm including but not limited to 1.0, 0.75, 0.5, 0.25, 0.2, 0.1, 0.075, 0.05, 0.025, 0.01, 0.0075, 0.005, 0.0025, 0.001, 0.0005, and 0.0001 millimeters.

Using bonding pads 625 and electrical connectors 618 (depicted as wire bonding in this embodiment), the leads 616c are extended from the substrate 602 to the PC carrier 610 where the leads 616c are in electrical communication with leads 616d. In this embodiment, the leads 616c are continued onto the PC carrier 610 in the form of the leads 616d where a chip bonding technique may be utilized, such as COG, TAB or COF for example, to place the array 604 in electrical communication with a driver chip 614 or other electrical components connected to the PC carrier 610.

Although bonding pads 625 and electrical connector 618 are illustrated using wire bonding, any type of connection device that allows for a reduced ledge area 619 is contemplated by the present invention. For example, one of ordinary skill in the art may substitute a flex cable connector for bonding pads 625 and may substitute a flex cable for electrical connector 618 while still providing for a reduced ledge area 619 of less than or equal to 1,0.75, 0.5, 0.25, or 0.1 millimeters.

The electrical connector 618 is mounted to the PC carrier 610 and transparent substrate 602 in order to provide electrical communication between the devices on the PC carrier 610 and the transparent substrate 602. Driver chip 614 can be placed in electrical connection with external circuitry through trace leads 616e and external interconnect pins 622. Approaches using COG, COF, or TAB may also be used in these embodiments. PC carrier 610 also provides physical support for additional electronic components 620 (e.g. ICs and passives) which can be connected to external circuitry via external interconnect pins 622 and trace leads 616f, or in connection with driver chip 614 via trace leads 616g. Certain of these electronic components, such as driver chips 612 and 614, provide a means for controlling the state of the modulators within the array 604.

PC carrier 610 can be a single or multilayer conductor polymer laminate which can be fabricated using any suitable technique. It can comprise one or more polymeric layers which provide structural support and/or insulation for one or more layers of interconnections comprising patterned or non-patterned conductors. The conductors provide electrical connections between the different components mounted on the surface. Because PC carrier 610 can be a multilayer conductor polymer laminate, the interconnections are not limited to trace leads on a surface of the carrier as depicted in the Figure 8, but may also include alternate interconnections such as leads located within the carrier 610.

Although the backplate 608 can provide a vapor transmission barrier sufficient to protect array 604 in the embodiment of Figure 8, in alternative embodiments the functions of the backplate 608 are performed by the carrier 610, thereby allowing for the elimination of the backplate 608. In such embodiments, the carrier may advantageously comprise materials which minimize or prevent vapor transmission. The skilled artisan will appreciate that PC carriers formed of FR4 will transmit water vapor at a relatively high rate. In some alternative embodiments, the PC carrier 610 may be formed of or include gold plated thin film metals to increase its impermeability to water. Other suitable materials for the carrier 610 include, but are not limited to, ceramics, aluminum nitride, beryllium oxide, and alumina. The PC carrier 610 may be formed of a board or a flexible sheet.

The PC carrier 610 serves to support the components which are associated with the display operation. The PC carrier 610 can be connected to additional PC carriers which carry components relevant to the overall operation of the product, or provide physical and electrical support to these components as well. Therefore, a component such as PC carrier 610 provides a means for supporting these electronic components. The PC carrier 610 may include electronic interfaces for use with radio-frequency (RF) signals. The skilled artisan will understand that the PC carrier 610 may serve not only as protection for circuitry that is integrated into the backplane but may also enhance RF circuit needs. For example, metal caps may be included for RF enhancement or protection. Antenna properties may also be incorporated into the PC carrier 610 or the interferometric modulator array 604, including, but not limited to, the use of a metal backplane or a metal cap as an antenna for a cell phone.

Although for simplicity only six trace leads 616a,c are shown connecting the driver chips 612 and 614 with array 604, it will be understood that many more trace leads may be necessary for the driver chips to control the state of the array 604, depending on the size of the array. Similarly, although only three trace leads 616b,e are depicted as connecting the driver chips with external circuitry, certain embodiments may require different numbers of input trace leads. Similarly, although for simplicity no trace leads are depicted in this figure as running to the top or bottom (with respect to the figure) of array 604, it will be understood that embodiments of the present invention can utilize the configurations discussed with respect to this and following figures to provide an electrical connection with any portion of the array 604 (e.g. to provide both row and column signals from driver circuitry). Also, although trace leads 616a,c are depicted as connecting to array 604, trace leads 616a,c may connect to any device within the cavity formed by the annular seal 606.

The trace leads 616a,c (alternately and interchangeably referred to as conductive busses or electrical traces) may comprise electrical traces formed from conductive material. These traces 616a,c may be between about 25 micrometers (µm) and 1 millimeter wide, e.g., about 50 micrometers across, and may be between about 0.1 micrometers (µm) to 1 micrometers (µm) thick. Larger or smaller sizes, however, are possible. The trace leads 616a,c may comprise metal in some embodiments. Photolithographic, electroplating, as well as electroless techniques may be employed to form the trace leads. In certain embodiments, a metal based slurry or silver paste may be employed. Other methods and materials may also be used to form the trace leads.

ACF materials may be conveniently employed for providing electrical interconnects between components, and they are often used to connect the flex connector of TAB drivers to display substrates. However, other connection methods can be employed and substituted for the exemplary embodiments disclosed in the Figures herein, including but not limited to zebra connectors, flex cables, bump bonds, wire bonds, and micromechanical pressure conductors (e.g. MEMS springs).

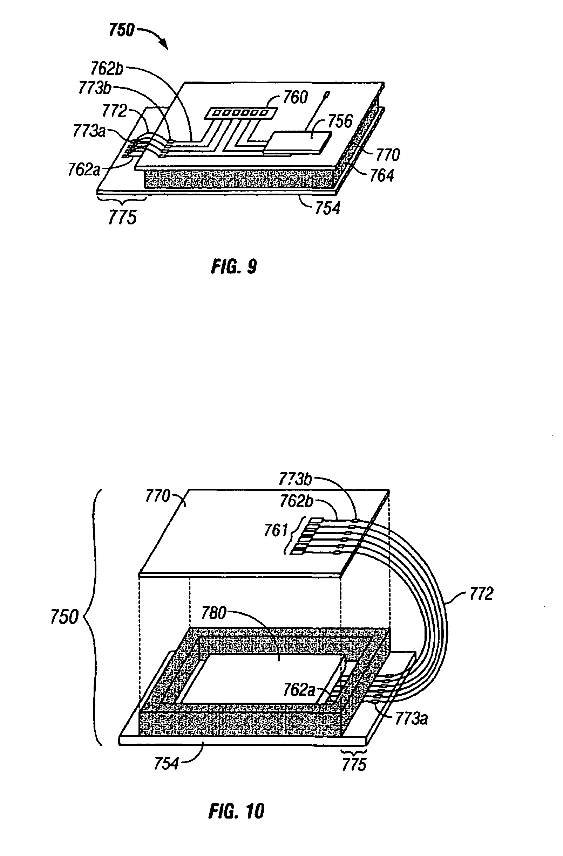

Figures 9 and 10 depict exemplary reduced footprint display devices 750. As will be apparent from the following discussion, the reduced footprint of the device 750 is due in part to the reduction in size of one or more of the extended ledges, such as ledge portion 613 seen in Figure 8, on which components such as driver chips and connections were located exterior to the protective cavity formed by the seal rings. These components that were once located on the extended ledge 613 may be located in a vertical dimension of the reduced footprint display device 750.

Figure 9 shows the device 750 in an assembled state and Figure 10 shows the device 750 in an exploded view. Referring to Figure 9, the device 750 includes a transparent substrate 754 which is sealed to a carrier 770 through a seal ring 764. In this embodiment, the carrier 770 acts as a backplate for the device 750.

The carrier 770 includes a first display circuit 756 in electrical connection with a set of external interconnect pins 760 for connecting the display device 750 to external devices. In addition, a set of interconnect leads 762b connect the display circuit 756 to a set of bonding pads 773b and an electrical connecting device 772 connected to the bonding pads 773b, which is depicted as wire bonding in this particular embodiment. The electrical connection device 772 provides an electrical connection to the interior components of the device 750 and extends down to the bonding pads 773a on a reduced ledge area 775 on the transparent substrate 754. Leads 762a then extend from the bonding pads 773a on the reduced ledge area 754 to the interior components of the display device 750. The reduced ledge area 775 in this embodiment extends from the outer edge of the seal ring 764 and the outside edge of the substrate 754. In exemplary embodiments, the reduced ledge area 775 is less than 1 mm in width, including but not limited to 0.75, 0.5, 0.25, 0.2, 0.1, 0.075, 0.05, 0.025, 0.01, 0.0075, 0.005, 0.0025, 0.001, 0.0005, and 0.0001 millimeters.

The use of the electrical connection device 772 allows for a reduced footprint in part because of the reduced ledge area 775 as compared to the extended ledge area 613 depicted in Figure 8. With the reduced ledge area 775, the space between any adjacent display devices 750 in an array of display devices 750 is minimized, thereby improving the image quality of the larger array of display devices 750. For example, if two display devices 750 were placed together in an array such that the reduced ledge areas 775 of the display devices 750 were adjacent, then the gap between the display devices 750 would be less than the gap if the ledge areas were extended, as depicted by the extended ledge area 613 in Figure 8.

With reference to Figure 10, an exploded view of the display device 750 is shown with the interior components 780 of the display device on the transparent substrate 754 in electrical communication with pads 761 on the carrier 770. The pads 761 on the carrier 770 may be used to connect to any device of interest, for example a driver chip or a flex cable that could lead to a PCB. In this embodiment, the interior components 780 of the device 750 are connected to leads 762a, which are connected to bonding pads 773a. The bonding pads 773a on the substrate 754 are then connected to the electrical connection device 772 (depicted here as wire bonding), which lead to the bonding pads 773b on the carrier 770. These bonding pads 773b on the carrier are then connected to pads 761 via leads 762b. In this embodiment, the interior components 780 in electrical communication with the electrical connection device 772 and pads 761 may be components such as an interferometric light modulator, an array of interferometric light modulators, or any other component of interest, including but not limited to sensing devices, lighting devices, or other display devices, such as LCDs or LEDs for example. It should also be understood that some or all of the driver chips could be placed on the lower surface of the carrier 770 and thereby inside of the sealed cavity formed by the carrier 770, the transparent substrate 754 and the seal ring 764.

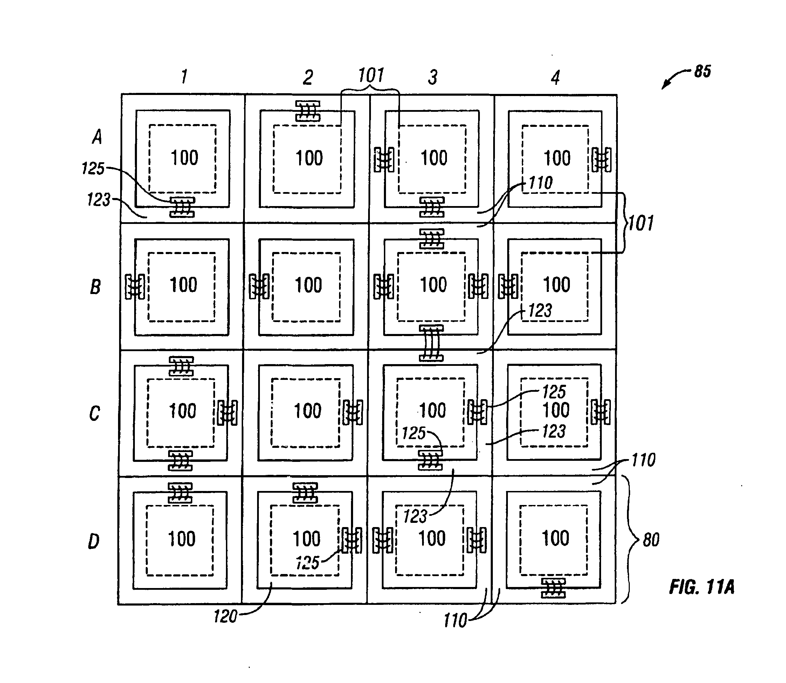

With reference to Figures 11A, an arrangement of a plurality of display devices 80 are configured into an array forming a larger display device 85 by tiling. Tiling involves the use of multiple display devices to create one larger system. Tiling is particularly useful for building larger displays and can be used when the largest producible display is smaller than the display size that is desired. For example, a billboard or other signage is typically too large to produce from a single piece of glass and the price to produce a large piece of glass could be quite high. Thus, tiling can be used to fill the space and advantageously, tiling is a cheaper alternative.

Displays are designed such that at the distance they are typically viewed at, the individual pixels are barely visible. Televisions, laptops and other devices are designed to have a spatial frequency of 10 to 20 cycles per degree. Spatial frequencies of about 80 cycles per degree are invisible to the best human eye. As a result, a distance between active display areas of about 1/8^{th} to 1/10^{th} of a pixel pitch ensures a spatial frequency greater than 80 cycles per degree for all applications. The pixel pitch is related to the resolution of the display. For example, a display at 1 pixel per inch (ppi) has a pixel pitch of 25.4 millimeters. When the tiling is constructed correctly, the spaces between the active areas should not be discernible to the eye. For example, if the space between the active areas is between about at 1/8^{th} to 1/10^{th} of a pixel pitch, the gap between the active areas will not be discernable to the naked eye.

Many types of display technologies may be tiled together into a larger array using the techniques disclosed herein, including but not limited to liquid crystal displays (LCD), organic light-emitting diodes (OLED), light-emitting diodes (LED), filed-emission displays (FED), electrophoretic displays, and MEMS including interferometric light modulators. Moreover, the tiling techniques disclosed herein are applicable to other types of technologies where it is desirable to minimize the distance between active areas of an array. For example, the techniques taught herein may apply to imaging sensors such as x-rays, complementary oxide semiconductors (CMOS), common channel signaling (CCS), infrared, and ultraviolet (UV) sensors. If the technology is more constrained on the footprint size of the device (x,y dimensions) than the vertical dimension (z), then the use of the reduced ledge area for interconnection as depicted in Figures 8-10 may be useful.

As used herein, active area is defined in its broadest ordinary meaning, including but not limited to an area of a device circumscribed by a seal. In some embodiments, the active area is an area surrounded by an annular seal where an electrical connection to the active area is desirable. For example, in some embodiments, the active area is an area of a display device where a person may view an image(s), an area of a device where light enters into or is reflected or projected from the device, or an area of a device where other forms of information enter or exit from the device, such as imaging sensing information. In another embodiment, the active area is an array of interferometric light modulators of a display device. In another embodiment, the active area is an array of sensors in a sensing device.

With reference to Figure 11A, a top view of a tiled array is shown with sixteen display devices 80. Each display device 80 includes an active area 100, packaging and interconnect areas 110, an inactive area 101 between active areas 100 of the array, a backplate 120 above the active area 100, and an electrical connection device 125 (depicted here as wire bonding). In one embodiment, the active area 100 of each display device 80 is a plurality of interferometric light modulators. The electrical connection device 125 connects components within the display device 80 (such as the active area 100) to electrical components on the backplate 120. In one embodiment, the connection device connects the array to a driver chip.

In one embodiment, each display device 80 is controlled by its own local driver circuit. In another embodiment, a main driver (not depicted) controls each local driver in order for all of the display devices 80 to work in unison. Once complete, the tiled display 85 can be used substantially like that of a large display, for example, it can produce a single full image. Moreover, because the tiled display 85 is an array of multiple display devices 80, the array 85 has the additional advantage of allowing a display of multiple or mixed images. Accordingly, in an exemplary embodiment, the array 85 of interferometric modulator display devices 80 are connected through a central controller device (not depicted) which will send to each display device 80 a desirable portion of the multiple or mixed images to produce on the larger tiled array 85 the complete multiple or mixed images. Thus, the array 85 may display different images on each of the individual display devices 80. Alternatively, the array 85 may display images that cross the boundaries of adjacent display devices 80, to produce one or more larger images on the array 85.

Tiling of individual display devices is particularly useful for producing images in larger formats, such as billboards and large television sets. In one embodiment, the array 85 of interferometric modulators 80 is controlled by a main display driver that controls each individual display device (tile) in the array. Thus, a complete large format image may be displayed on the array 85 of interferometric modulator display devices 80 to produce a complete image on a billboard, for example.

Alternatively, one or more display devices 80 within the array 85 can display its own image. For example, the tiled array 85 shown in Figure 11A may have four separate images, with each image being displayed across four display devices 80. Thus, several complete images may be displayed on one tiled array 85, up to the number of display devices 80 which are used, 16 in Figure 11A. In one exemplary embodiment, the array 85 includes multiple display devices 80 including from about 2 to about 20,000 display devices. In further exemplary embodiments, the tiled array 85 may include from about 2 to about 17, 000 display devices 80, including but not limited to: 2, 4, 8, 16, 32, 64, 128, 256, 512, 1024, 2048, 4096, 8192, and 16284. In further exemplary embodiments, the tiled array 85 can include from about 2 to about 1024 display devices 80, including but not limited to 4, 8, 16, 32, 64, 128, 256, and 512. In further exemplary embodiments, the display devices comprise interferometric modulator display devices.

With reference to Figures 11A, in one embodiment, the use of wire bonding allows for a reduced inactive area 101 between active areas 100. In one embodiment, by using wire bonding 125 to connect the active area 100 to a driver or PCB (not depicted) connected to the backplate 120, the inter-tile area 110 between adjacent display devices 80 is reduced, thereby improving the image quality of the tiled array 85.

In embodiments comprising a reduced inter-tile area 110 and wire bonds 125, the wire bonding comprises at least one wire, but may have multiple wires. When in use, the wire bonds can be attached in any way which is effective to minimize the inactive area 101 in the inter-tile area 110.

When the ledge area is minimized using certain embodiments and methods described herein, electrical connections between components on the substrate of a device and components on the backplate above the substrate are attached in a vertically dimension rather than a horizontal dimension, thereby reducing the space between active areas of the devices and improving the image quality of the device.

With reference to Figure 11A, the electrical connection device between components on the substrate of a device and components on the backplate, such as the wire bonding 125 in Figure 11A, may be placed on one or more ledges configured to couple to such electrical connection devices. For example, as depicted in Figure 11A at display device 80 in grid space (A,1), the electrical connection device 125 is depicted as being on a single ledge 123. However, the electrical connection device may be on one or more of the ledges on a device, such as is depicted in Figure 11A at grid space (C,3). The electrical connection device 125 may also be on adjacent ledges of a display device 80, such as depicted in space (D,2) or on two parallel ledges of a display device 80, such as depicted in space (D,3). Moreover, it is possible to have electrical connection devices 125 of adjacent display devices 80 be parallel one another, such as depicted in spaces (D,2) and (D,3). Many other configurations are possible.

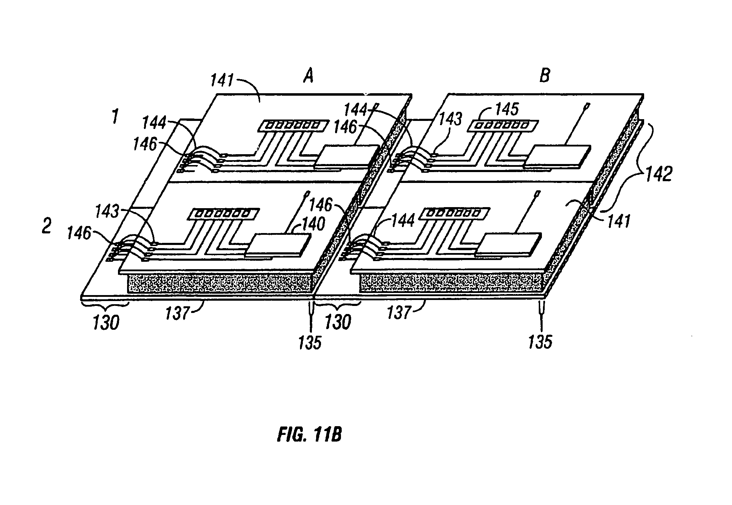

With reference to Figure 11B, an array of four display devices 142 is depicted, each having a reduced ledge area 130 where bonding pads 146 connect to an interior component(s) of the display device 142. The bonding pads 146 connect to wire bonding 144 that leads to bonding pads 143 on a backplate 141. The bonding pads 143 on the backplate 141 are also connected to leads 147 that allow connection to other electrical devices such as a driver chip 140 or external interconnect pins/pads 145. In this embodiment, when the bonding pads 146 exist on a ledge 130 that is not adjacent to another display device 142, as depicted at display device 142 in spaces (B,1) and (B,2), the ledge 130 does not have to be reduced since there are no other display devices 142 adjacent that ledge 130. As long as the ledge 130 is reduced for ledges 130 that are adjacent other display devices 142, such as the display devices 142 in spaces (A,1) and (A,2), then the space between the active display areas is reduced and the image quality of the arrayed display device is increased.

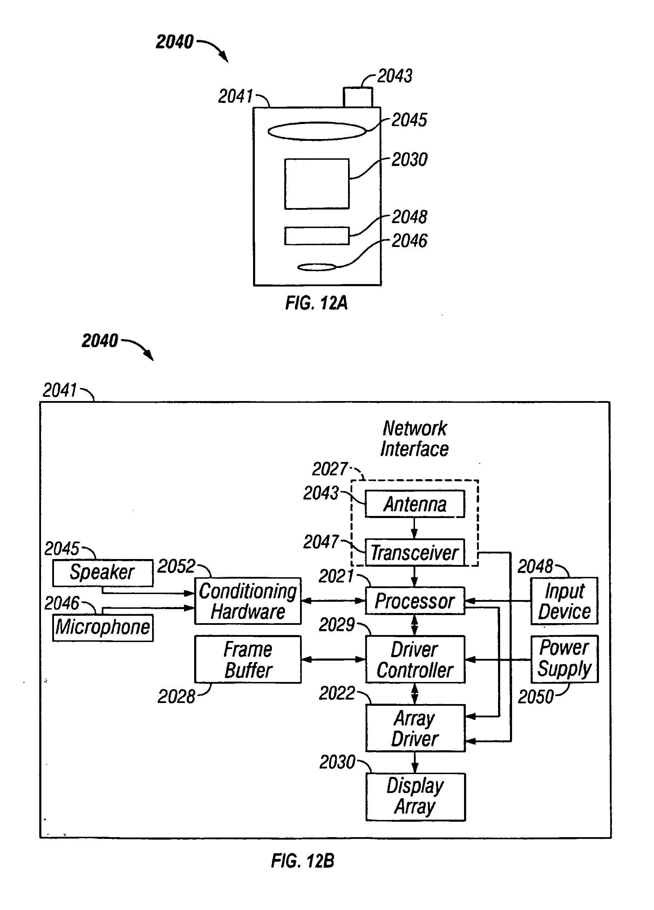

Figures 12A and 12B are system block diagrams illustrating an embodiment of a display device 2040. The display device 2040 can be, for example, a cellular or mobile telephone. However, the same components of display device 2040 or slight variations thereof are also illustrative of various types of display devices such as televisions and portable media players.

The display device 2040 includes a housing 2041, a display 2030, an antenna 2043, a speaker 2045, an input device 2048, and a microphone 2046. The housing 2041 is generally formed from any of a variety of manufacturing processes as are well known to those of skill in the art, including injection molding, and vacuum forming. In addition, the housing 2041 may be made from any of a variety of materials, including but not limited to plastic, metal, glass, rubber, and ceramic, or a combination thereof. In one embodiment the housing 2041 includes removable portions (not shown) that may be interchanged with other removable portions of different color, or containing different logos, pictures, or symbols.

The display 2030 of exemplary display device 2040 may be any of a variety of displays, including a bi-stable display, as described herein. In other embodiments, the display 2030 includes a flat-panel display, such as plasma, EL, OLED, STN LCD, or TFT LCD as described above, or a non-flat-panel display, such as a CRT or other tube device, as is well known to those of skill in the art. However, for purposes of describing the present embodiment, the display 2030 includes an interferometric modulator display, as described herein.

The components of one embodiment of exemplary display device 2040 are schematically illustrated in Figure 12B. The illustrated exemplary display device 2040 includes a housing 2041 and can include additional components at least partially enclosed therein. For example, in one embodiment, the exemplary display device 2040 includes a network interface 2027 that includes an antenna 2043 which is coupled to a transceiver 2047. The transceiver 2047 is connected to the processor 2021, which is connected to conditioning hardware 2052. The conditioning hardware 2052 may be configured to condition a signal (e.g. filter a signal). The conditioning hardware 2052 is connected to a speaker 2045 and a microphone 2046. The processor 2021 is also connected to an input device 2048 and a driver controller 2029. The driver controller 2029 is coupled to a frame buffer 2028 and to the array driver 2022, which in turn is coupled to a display array 2030. A power supply 2050 provides power to all components as required by the particular exemplary display device 2040 design.

The network interface 2027 includes the antenna 2043 and the transceiver 2047 so that the exemplary display device 2040 can communicate with one or more devices over a network. In one embodiment the network interface 2027 may also have some processing capabilities to relieve requirements of the processor 2021. The antenna 2043 is any antenna known to those of skill in the art for transmitting and receiving signals. In one embodiment, the antenna transmits and receives RF signals according to the IEEE 802.11 standard, including IEEE 802.11(a), (b), or (g). In another embodiment, the antenna transmits and receives RF signals according to the BLUETOOTH standard. In the case of a cellular telephone, the antenna is designed to receive CDMA, GSM, AMPS or other known signals that are used to communicate within a wireless cell phone network. The transceiver 2047 pre-processes the signals received from the antenna 2043 so that they may be received by and further manipulated by the processor 2021. The transceiver 2047 also processes signals received from the processor 2021 so that they may be transmitted from the exemplary display device 2040 via the antenna 2043.

In an alternative embodiment, the transceiver 2047 can be replaced by a receiver. In yet another alternative embodiment, network interface 2027 can be replaced by an image source, which can store or generate image data to be sent to the processor 2021. For example, the image source can be a digital video disc (DVD) or a hard-disc drive that contains image data, or a software module that generates image data.

Processor 2021 generally controls the overall operation of the exemplary display device 2040. The processor 2021 receives data, such as compressed image data from the network interface 2027 or an image source, and processes the data into raw image data or into a format that is readily processed into raw image data. The processor 2021 then sends the processed data to the driver controller 2029 or to frame buffer 2028 for storage. Raw data typically refers to the information that identifies the image characteristics at each location within an image. For example, such image characteristics can include color, saturation, and gray-scale level.

In one embodiment, the processor 2021 includes a microcontroller, CPU, or logic unit to control operation of the exemplary display device 2040. Conditioning hardware 2052 generally includes amplifiers and filters for transmitting signals to the speaker 2045, and for receiving signals from the microphone 2046. Conditioning hardware 2052 may be discrete components within the exemplary display device 2040, or may be incorporated within the processor 2021 or other components.

The driver controller 2029 takes the raw image data generated by the processor 2021 either directly from the processor 2021 or from the frame buffer 2028 and reformats the raw image data appropriately for high speed transmission to the array driver 2022. Specifically, the driver controller 2029 reformats the raw image data into a data flow having a raster-like format, such that it has a time order suitable for scanning across the display array 2030. Then the driver controller 2029 sends the formatted information to the array driver 2022. Although a driver controller 2029, such as a LCD controller, is often associated with the system processor 2021 as a stand-alone Integrated Circuit (IC), such controllers may be implemented in many ways. They may be embedded in the processor 2021 as hardware, embedded in the processor 2021 as software, or fully integrated in hardware with the array driver 2022.

Typically, the array driver 2022 receives the formatted information from the driver controller 2029 and reformats the video data into a parallel set of waveforms that are applied many times per second to the hundreds and sometimes thousands of leads coming from the display's x-y matrix of pixels.

In one embodiment, the driver controller 2029, array driver 2022, and display array 2030 are appropriate for any of the types of displays described herein. For example, in one embodiment, driver controller 2029 is a conventional display controller or a bi-stable display controller (e.g., an interferometric modulator controller). In another embodiment, array driver 2022 is a conventional driver or a bi-stable display driver (e.g., an interferometric modulator display). In one embodiment, a driver controller 2029 is integrated with the array driver 2022. Such an embodiment is common in highly integrated systems such as cellular phones, watches, and other small area displays. In yet another embodiment, display array 2030 is a typical display array or a bi-stable display array (e.g., a display including an array of interferometric modulators).

The input device 2048 allows a user to control the operation of the exemplary display device 2040. In one embodiment, input device 2048 includes a keypad, such as a QWERTY keyboard or a telephone keypad, a button, a switch, a touch-sensitive screen, a pressure- or heat-sensitive membrane. In one embodiment, the microphone 2046 is an input device for the exemplary display device 2040. When the microphone 2046 is used to input data to the device, voice commands may be provided by a user for controlling operations of the exemplary display device 2040.

Power supply 2050 can include a variety of energy storage devices as are well known in the art. For example, in one embodiment, power supply 2050 is a rechargeable battery, such as a nickel-cadmium battery or a lithium ion battery. In another embodiment, power supply 2050 is a renewable energy source, a capacitor, or a solar cell, including a plastic solar cell, and solar-cell paint. In another embodiment, power supply 2050 is configured to receive power from a wall outlet.

In some implementations control programmability resides, as describedabove, in a driver controller which can be located in several places in the electronic display system. In some cases control programmability resides in the array driver 2022. Those of skill in the art will recognize that the above-described optimization may be implemented in any number of hardware and/or software components and in various configurations.

## Claims

1. A method of manufacturing an array of display devices, comprising:
providing a first display device (80) having
a display package comprising:
a substrate (602) including a first active area (100), and an electrical connection area (619) on a ledge area of the substrate (602), wherein said electrical connection area (619) is configured to provide electrical communication with said first active area (100);
a sealant ring (606) circumscribing said first active area (100);
a backplane (608; 120) joined to said sealant ring (606) to form said display package with the substrate (602); and
wire bonding (625, 618) for providing electrical communication between said electrical connection area (619) and bonding pads on a surface of the backplane (120; 608, 610) opposite to the substrate (602);
providing a second display device (180) comprising a second active area (100); and
positioning the first display device (80) adjacent to the second display device (80) such that the active area of the second display device is adjacent to the electrical connection area of the first display device, wherein said ledge area (130; 619) of said first device extends from sealant ring (606) to the edge of the substrate (602) adjacent the second display device by no more than 1 millimeter.

2. The method of claim 1, wherein each of the first and second active areas comprise an array of pixels and the shortest distance between the first active area and the second active area is less than or equal to 1/8 ^{th} of a pixel pitch.

3. The method of claim 1, wherein the array of display devices (80) comprises at least one interferometric light modulator.

4. The method of claim 3, wherein the first active area (100) and the second active area (100) each comprise at least one interferometric light modulator.

5. An array of devices, comprising:
a first device, comprising:
transmitting means (602) for transmitting light therethrough;
first active means (100; 604) for modulating light transmitted through said transmitting means (602);
sealing means (606) sealing said first active means (100; 604), said stealing means (606) circumscribing said first active means (100; 604);
covering means (120; 608, 610) forming a package with said transmitting means (602), said first active means (100; 604) and said sealing means (606); and
electrical connection means (625, 618) for providing electrical communication between said first active means (100, 604) and a surface of the covering means (120; 608, 610) opposite to said transmitting means (602);
wherein said electrical connection means (625, 618) is disposed in a ledge area of the transmitting means (602) defining an electrical connection area (130; 619); and
a second device comprising a second active means for reflecting light, and positioned adjacent to the electrical connection area (130; 619) of said first device;
wherein said ledge area (130; 619) of said first device extends from said sealing means (606) to an edge of said transmitting means (602) adjacent the second device by no more than 1 millimeter.

6. The array of devices of claim 5, wherein said transmitting means comprises a transparent substrate (602).

7. The array of devices of claim 5 or 6, wherein said first active means comprises an array of interferometric modulators (604).

8. The array of devices of claim 5, 6 or 7, wherein said sealing means (606) comprises a sealant.

9. The array of devices of any one of claims 5 to 8, wherein said covering means comprises a backplane (608).

10. The array of devices of any one of claims 5 to 9, wherein said second active means comprises an array of interferometric modulators.

11. The array of devices of claim 5, wherein said electrical connection means (625) is configured to provide electrical communication with said first active means via wire bonding.

12. The array of devices of claim 5, wherein each of the first and second active areas comprise an array of pixels and a shortest distance between the first active means and the second active means is less than or equal to 1/8^{th} of a pixel pitch.

13. The array of devices of claim 5, wherein the array of devices comprises an array of display devices.

14. The array of devices of claim 13, wherein the array of display devices is configured to display a single image.

15. The array of devices of claim 13, wherein the array of display devices is configured to display multiple images simultaneously.

16. The array of devices of claim 5, wherein the display devices comprise at least one of the following: a liquid crystal display, LCD, an organic light-emitting diode, OLED, a light-emitting diodes, LED, a filed-emission displays, FED, an electrochromatic display, or an electrophoretic display.

17. The array of devices of claim 5, wherein the devices comprise one of the following imaging sensing devices: an x-ray sensor, a complementary metal oxide semiconductors, CMOS, sensor, a common channel signaling, CCS, sensor, an infrared sensor, or an ultraviolet, UV, sensor.

18. The array of devices of claim 5, wherein the electrical connection area comprises a spacing between said sealing means (606) and the edge of less than or equal to 0.75 millimeters.

19. The array of devices of claim 5, wherein the electrical connection area (619) comprises a spacing between said sealing means (606) and the edge of less than or equal to 0.5 millimeters.

20. The array of devices of claim 5, wherein the electrical connection area (619) comprises a spacing between said sealing means (606) and the edge of less than or equal to 0.25 millimeters.

21. The array of devices of claim 5, wherein the electrical connection area (619) comprises a spacing between said sealing means (606) and the edge of less than or equal to 0.1 millimeters.

22. The array of devices of claim 9, wherein the backplate (608) comprises a printed circuit board (610).

23. The array of devices of claim 5, further comprising:
a processor that is in electrical communication with said first active means, said processor being configured to process image data; and
a memory device in electrical communication with said processor.

24. The array of devices of claim 23, further comprising a driver circuit (614) configured to send at least one signal to said first active means.

25. The array of devices of claim 24, further comprising a controller configured to send at least a portion of said image data to said driver circuit.

26. The array of devices of claim 24, further comprising an image source module configured to send said image data to said processor.

27. The array of devices of claim 25, wherein said image source module comprises at least one of a receiver, transceiver, and transmitter.

28. The array of devices of claim 23, further comprising an input device configured to receive input data and to communicate said input data to said processor.

29. The array of devices of any one of claims 5 to 28 produced by the method of claim 1.

30. The array of devices of any one of claims 5 to 29, wherein said electrical connection means is connected to a driver circuit (614) on said covering means (120; 608, 610).

31. The array of devices of any one of claims 5 to 30 wherein the covering means (120; 608, 610) of the first device further comprises a printed circuit carrier (610) for electrical components (614, 620) on said surface of said covering means (120, 608, 610).

## Patentansprüche

1. Verfahren zur Herstellung einer Anordnung aus Anzeigevorrichtungen, umfassend:
Bereitstellen einer ersten Anzeigevorrichtung (80) mit einem Anzeigepaket, umfassend:
ein Substrat (602), einschließlich einer ersten aktiven Fläche (100), und eine elektrische Verbindungsfläche (619) an einer Kantenfläche des Substrats (602), wobei die elektrische Verbindungsfläche (619) konfiguriert ist, um eine elektrische Kommunikation mit der ersten aktiven Fläche (100) bereitzustellen;
eine Einfassung aus Dichtungsmasse (606), welche die erste aktive Fläche (100) begrenzt;
eine Rückwandplatte (608, 120), die mit der Einfassung aus Dichtungsmasse (606) verbunden ist, um das Anzeigepaket mit dem Substrat (602) zu bilden;
Drahtbonden (625, 618) zum Bereitstellen einer elektrischen Kommunikation zwischen der elektrischen Verbindungsfläche (619) und Kontaktierflächen auf der Oberfläche der Rückwandplatte (120, 608, 610) gegenüber dem Substrat (602);
Bereitstellen einer zweiten Anzeigevorrichtung (180), umfassend eine zweite aktive Fläche (100); und
Positionieren der ersten Anzeigevorrichtung (80) neben der zweiten Anzeigevorrichtung (80), so dass die aktive Fläche der zweiten Anzeigevorrichtung neben der elektrischen Verbindungsfläche der ersten Anzeigevorrichtung liegt, wobei sich die Kantenfläche (130, 619) der ersten Vorrichtung von der Einfassung aus Dichtungsmasse (606) zur Kante des Substrats (602) erstreckt, die maximal 1 Millimeter neben der zweiten Anzeigevorrichtung liegt.

2. Verfahren nach Anspruch 1, wobei jede der ersten und zweiten aktiven Fläche eine Anordnung aus Pixeln umfasst und der kürzeste Abstand zwischen der ersten aktiven Fläche und der zweiten aktiven Fläche kleiner oder gleich 1/8tel eines Pixelabstandes ist.

3. Verfahren nach Anspruch 1, wobei die Anordnung aus Anzeigevorrichtungen (80) mindestens einen interferometrischen Lichtmodulator umfasst.

4. Verfahren nach Anspruch 3, wobei die erste aktive Fläche (100) und die zweite aktive Fläche (100) jeweils mindestens einen interferometrischen Lichtmodulator umfassen.

5. Anordnung aus Vorrichtungen, umfassend:
eine erste Vorrichtung, umfassend:
Übertragungsmittel (602), zum Übertragen von Licht;
ein erstes aktives Mittel (100, 604) zum Modulieren von Licht, das durch das Übertragungsmittel (602) übertragen wird;
Dichtungsmittel (606), welches das erste aktive Mittel (100, 604) abdichtet, wobei das Dichtungsmittel (606) das erste aktive Mittel (100, 604) begrenzt;
Abdeckmittel (120, 608, 610), welches ein Paket mit dem Übertragungsmittel (602), dem ersten aktiven Mittel (100, 604) und dem Dichtungsmittel (606) bildet; und
ein elektrisches Verbindungsmittel (625, 618) zum Bereitstellen einer elektrischen Kommunikation zwischen dem ersten aktiven Mittel (100, 604) und einer Oberfläche des Abdeckmittels (120, 608, 610) gegenüber dem Übertragungsmittel (602);
wobei das elektrische Verbindungsmittel (625, 618) in einer Kantenfläche des Übertragungsmittels (602) angeordnet ist und eine elektrische Verbindungsfläche (130, 619) definiert; und
eine zweite Vorrichtung, umfassend ein zweites aktives Mittel zum Reflektieren von Licht, das neben der elektrischen Verbindungsfläche (130, 619) der ersten Vorrichtung positioniert ist;
wobei sich die Kantenfläche (130, 619) der ersten Vorrichtung von dem Dichtungsmittel (606) zur Kante des Übertragungsmittels (602) neben der zweiten Vorrichtung um maximal 1 Millimeter erstreckt.

6. Anordnung aus Vorrichtungen nach Anspruch 5, wobei das Übertragungsmittel ein transparentes Substrat (602) umfasst.

7. Anordnung aus Vorrichtungen nach Anspruch 5 oder 6, wobei das erste aktive Mittel eine Anordnung aus interferometrischen Modulatoren (604) umfasst.

8. Anordnung aus Vorrichtungen nach Anspruch 5, 6 oder 7, wobei das Dichtungsmittel (606) eine Dichtungsmasse umfasst.

9. Anordnung aus Vorrichtungen nach Anspruch 5 bis 8, wobei das Abdeckmittel eine Rückwandplatte (608) umfasst.

10. Anordnung aus Vorrichtungen nach Anspruch 5 bis 9, wobei das zweite aktive Mittel eine Anordnung aus interferometrischen Modulatoren umfasst.

11. Anordnung aus Vorrichtungen nach Anspruch 5, wobei das elektrische Verbindungsmittel (625) konfiguriert ist, um eine elektrische Kommunikation mit dem ersten aktiven Mittel über Drahtbonden bereitzustellen.

12. Anordnung aus Vorrichtungen nach Anspruch 5, wobei jede der ersten und zweiten aktiven Fläche eine Anordnung aus Pixeln umfasst und der kürzeste Abstand zwischen dem ersten aktiven Mittel und dem zweiten aktiven Mittel kleiner als oder gleich 1/8tel eines Pixelabstandes ist.

13. Anordnung aus Vorrichtungen nach Anspruch 5, wobei die Anordnung aus Vorrichtungen eine Anordnung aus Anzeigevorrichtungen umfasst.

14. Anordnung aus Vorrichtungen nach Anspruch 13, wobei die Anordnung aus Anzeigevorrichtungen konfiguriert ist, um ein einzelnes Bild anzuzeigen.

15. Anordnung aus Vorrichtungen nach Anspruch 13, wobei die Anordnung aus Anzeigevorrichtungen konfiguriert ist, um mehrere Bilder gleichzeitig anzuzeigen.

16. Anordnung aus Vorrichtungen nach Anspruch 5, wobei die Anzeigevorrichtungen mindestens eines der folgenden umfassen: eine Flüssigkristallanzeige LCD, eine organische Leuchtdiode OLED, eine Leuchtdiode LED, eine Feldemissionsanzeige FED, eine elektrochromatische Anzeige oder eine elektrophoretische Anzeige.

17. Anordnung aus Vorrichtungen nach Anspruch 5, wobei die Vorrichtungen eines der folgenden bildgebenden Messinstrumente umfassen: einen Röntgenstrahlsensor, einen komplementären MetallOxid-Halbleiter-CMOS-Sensor, einen gemeinsamen Kanalsignal-CCS-Sensor, einen Infrarotsensor oder einen Ultraviolett-UV-Sensor.

18. Anordnung aus Vorrichtungen nach Anspruch 5, wobei die elektrische Verbindungsfläche zwischen dem Dichtungsmittel (606) und der Kante einen Abstand von weniger als oder gleich 0,75 Millimeter umfasst.

19. Anordnung aus Vorrichtungen nach Anspruch 5, wobei die elektrische Verbindungsfläche (619) zwischen dem Dichtungsmittel (606) und der Kante einen Abstand von weniger als oder gleich 0,5 Millimeter umfasst.

20. Anordnung aus Vorrichtungen nach Anspruch 5, wobei die elektrische Verbindungsfläche (619) zwischen dem Dichtungsmittel (606) und der Kante einen Abstand von weniger als oder gleich 0,25 Millimeter umfasst.

21. Anordnung aus Vorrichtungen nach Anspruch 5, wobei die elektrische Verbindungsfläche (619) zwischen dem Dichtungsmittel (606) und der Kante einen Abstand von weniger als oder gleich 0,1 Millimeter umfasst.

22. Anordnung aus Vorrichtungen nach Anspruch 9, wobei die Rückwandplatte (608) eine Leiterplatte (610) umfasst.

23. Anordnung aus Vorrichtungen nach Anspruch 5, ferner umfassend:
einen Prozessor, der elektrisch mit dem ersten aktiven Mittel kommuniziert, wobei der Prozessor konfiguriert ist, um Bilddaten zu verarbeiten; und
eine Speichervorrichtung in elektrischer Kommunikation mit dem Prozessor.

24. Anordnung aus Vorrichtungen nach Anspruch 23, ferner umfassend eine Treiberschaltung (614), die konfiguriert ist, um mindestens ein Signal an das erste aktive Mittel zu senden.

25. Anordnung aus Vorrichtungen nach Anspruch 24, ferner umfassend eine Steuerung, die konfiguriert ist, um mindestens einen Teil der Bilddaten an die Treiberschaltung zu senden.

26. Anordnung aus Vorrichtungen nach Anspruch 24, ferner umfassend ein Bildquellenmodul, das konfiguriert ist, um die Bilddaten an den Prozessor zu senden.

27. Anordnung aus Vorrichtungen nach Anspruch 25, wobei das Bildquellenmodul mindestens entweder einen Empfänger, ein Sende-Empfangsgerät oder einen Sender umfasst.

28. Anordnung aus Vorrichtungen nach Anspruch 23, ferner umfassend eine Eingabevorrichtung, die konfiguriert ist, um die Eingabedaten zu empfangen und an den Prozessor zu kommunizieren.

29. Anordnung aus Vorrichtungen nach einem der Ansprüche 5 bis 28, hergestellt durch das Verfahren nach Anspruch 1.

30. Anordnung aus Vorrichtungen nach einem der Ansprüche 5 bis 29, wobei das elektrische Verbindungsmittel mit einer Treiberschaltung (614) auf dem Abdeckmittel (120, 608, 610) verbunden ist.

31. Anordnung aus Vorrichtungen nach einem der Ansprüche 5 bis 30, wobei das Abdeckmittel (120, 608, 610) der ersten Vorrichtung ferner eine Leiterplatte (610) für elektrische Komponenten (614, 620) auf der Oberfläche des Abdeckmittels (120, 608, 610) umfasst.

## Revendications

1. Procédé de fabrication d'une matrice de dispositifs d'affichage, comprenant :
la fourniture d'un premier dispositif d'affichage (80) comportant un ensemble d'affichage comprenant :
un substrat (602) incluant une première zone active (100) et une zone de connexion électrique (619) sur une zone de rebord du substrat (602), dans lequel ladite zone de connexion électrique (619) est configurée de manière à effectuer une connexion électrique avec ladite première zone active (100) ;
un anneau d'étanchéité (606) entourant ladite première zone active (100) ;
un panneau arrière (608; 120) relié audit anneau d'étanchéité (606) afin de former ledit ensemble d'affichage avec le substrat (602) ; et
une connexion par fil (625, 618) pour réaliser une communication électrique entre ladite zone de connexion électrique (619) et des plots de liaison situés sur une surface du panneau arrière (120; 608, 610) opposée au substrat (602) ;
la fourniture d'un second dispositif d'affichage (180) comprenant une seconde zone active (100) ; et
le positionnement du premier dispositif d'affichage (80) de manière adjacente au second dispositif d'affichage (80) de façon que la zone active du second dispositif d'affichage soit adjacente à la zone de connexion électrique du premier dispositif d'affichage, dans lequel ladite zone de rebord (130 ; 619) dudit premier dispositif s'étend depuis l'anneau d'étanchéité (606) jusqu'au bord du substrat (602) adjacent aux second dispositif d'affichage d'une distance ne dépassant pas 1 millimètre.

2. Procédé selon la revendication 1, dans lequel chacune des première et seconde zones actives comprend une matrice de pixels et la distance la plus courte entre la première zone active et la seconde zone active est inférieure ou égale à 1/8 de l'espacement entre pixels.

3. Procédé selon la revendication 1, dans lequel la matrice de dispositifs d'affichage (80) comprend au moins un modulateur de lumière interférométrique.

4. Procédé selon la revendication 3, dans lequel la première zone active (100) et la seconde zone active (100) comprennent chacune au moins un modulateur de lumière interférométrique.

5. Matrice de dispositifs comprenant:
un premier dispositif comprenant :
un moyen de transmission (602) pour transmettre de la lumière à travers celui-ci ;
un premier moyen actif (100 ; 604) pour moduler la lumière transmise à travers ledit moyen de transmission (602) ;
un moyen d'étanchéité (606) obturant de manière étanche ledit premier moyen actif (100; 604), ledit moyen d'étanchéité (606) entourant ledit premier moyen actif (100 ; 604) ;
un moyen de recouvrement (120; 608, 610) formant un ensemble avec ledit moyen de transmission (602), ledit premier moyen actif (100; 604) et ledit moyen d'étanchéité (606) ; et
un moyen de connexion électrique (625, 618) pour réaliser une communication électrique entre ledit premier moyen actif (100, 604) et une surface du moyen de recouvrement (120; 608, 610) opposée audit moyen de transmission (602) ;
dans laquelle ledit moyen de connexion électrique (625, 618) est disposé sur une zone de rebord du moyen de transmission (602) définissant une zone de connexion électrique (130 ; 619) ; et
un second dispositif comprenant un second moyen actif pour réfléchir la lumière, et positionné de manière adjacente à la première zone de connexion électrique (130 ; 619) dudit premier dispositif;
dans lequel ladite zone de rebord (130; 619) dudit premier dispositif s'étend depuis ledit moyen d'étanchéité (606) jusqu'à un bord dudit moyen de transmission (602) adjacent au second dispositif d'une distance ne dépassant pas 1 millimètre.

6. Matrice de dispositifs selon la revendication 5, dans laquelle ledit moyen de transmission comprend un substrat transparent (602).

7. Matrice de dispositifs selon la revendication 5 ou 6, dans laquelle ledit premier moyen actif comprend une matrice de modulateurs interférométriques (604).

8. Matrice de dispositifs selon la revendication 5, 6 ou 7, dans laquelle ledit moyen d'étanchéité (606) comprend un produit d'étanchéité.

9. Matrice de dispositifs selon l'une quelconque des revendications 5 à 8, dans laquelle ledit moyen de recouvrement comprend un panneau arrière (608).

10. Matrice de dispositifs selon l'une quelconque des revendications 5 à 9, dans laquelle ledit second moyen actif comprend une matrice de modulateurs interférométriques.

11. Matrice de dispositifs selon la revendication 5, dans laquelle ledit moyen de connexion électrique (625) est configuré pour réaliser une communication électrique avec ledit premier moyen actif par l'intermédiaire d'une connexion par fil.

12. Matrice de dispositifs selon la revendication 5, dans laquelle chacune des première et seconde zones actives comprend une matrice de pixels et la distance la plus courte entre le premier moyen actif et le second moyen actif est inférieure ou égale à 1/8 de l'espacement entre pixels.

13. Matrice de dispositifs selon la revendication 5, dans laquelle la matrice de dispositifs comprend une matrice de dispositifs d'affichage.

14. Matrice de dispositifs selon la revendication 13, dans laquelle la matrice de dispositifs d'affichage est configurée pour afficher une image unique.

15. Matrice de dispositifs selon la revendication 13, dans laquelle la matrice de dispositifs d'affichage est configurée pour afficher plusieurs images en même temps.

16. Matrice de dispositifs selon la revendication 5, dans laquelle les dispositifs d'affichage comprennent au moins un élément parmi les suivants : un dispositif d'affichage à cristaux liquides, LCD, une diode électroluminescente organique, OLED, une diode électroluminescente, LED, un dispositif d'affichage à effet de champ, FED, un dispositif d'affichage électrochromatique ou un dispositif d'affichage électrophorétique.

17. Matrice de dispositifs selon la revendication 5, dans laquelle les dispositifs comprennent l'un des dispositifs de détection d'image suivants : un détecteur de rayons X, un détecteur métal-oxyde-semi-conducteur complémentaire, CMOS, un détecteur de signalisation sur voie commune, CCS, un détecteur d'infrarouge ou un détecteur d'ultraviolet, UV.

18. Matrice de dispositifs selon la revendication 5, dans laquelle la zone de connexion électrique comprend un espace entre ledit moyen d'étanchéité (606) et le bord, inférieur ou égal à 0,75 millimètre.

19. Matrice de dispositifs selon la revendication 5, dans laquelle la zone de connexion électrique (619) comprend un espace entre ledit moyen d'étanchéité (606) et le bord, inférieur ou égal à 0,5 millimètre.

20. Matrice de dispositifs selon la revendication 5, dans laquelle la zone de connexion électrique (619) comprend un espace entre ledit moyen d'étanchéité (606) et le bord, inférieur ou égal à 0,25 millimètre.

21. Matrice de dispositifs selon la revendication 5, dans laquelle la zone de connexion électrique (619) comprend un espace entre ledit moyen d'étanchéité (606) et le bord, inférieur ou égal à 0,1 millimètre.

22. Matrice de dispositifs selon la revendication 9, dans laquelle le panneau arrière (608) comprend une carte de circuit imprimé (610).

23. Matrice de dispositifs selon la revendication 5, comprenant en outre :
un processeur en communication électrique avec ledit premier moyen actif, ledit processeur étant configuré pour traiter des données d'images ; et
un dispositif mémoire en communication électrique avec ledit processeur.

24. Matrice de dispositifs selon la revendication 23, comprenant en outre un circuit de commande (614) configuré pour envoyer au moins un signal audit premier moyen actif.

25. Matrice de dispositifs selon la revendication 24, comprenant en outre un contrôleur configuré pour envoyer au moins une partie desdites données d'images audit circuit de commande.

26. Matrice de dispositifs selon la revendication 24, comprenant en outre un module source d'image configuré pour envoyer lesdites données d'images audit processeur.

27. Matrice de dispositifs selon la revendication 25, dans laquelle ledit module source d'image comprend au moins un élément parmi un récepteur, un émetteur-récepteur et un émetteur.

28. Matrice de dispositifs selon la revendication 23, comprenant en outre un dispositif d'entrée configuré pour recevoir des données d'entrée et pour communiquer lesdites données d'entrée audit processeur.

29. Matrice de dispositifs selon l'une quelconque des revendications 5 à 28 réalisée par le procédé selon la revendication 1.

30. Matrice de dispositifs selon l'une quelconque des revendications 5 à 29, dans laquelle ledit moyen de connexion électrique est connecté à un circuit de commande (614) sur ledit moyen de recouvrement (120; 608, 610).

31. Matrice de dispositifs selon l'une quelconque des revendications 5 à 30, dans laquelle le moyen de recouvrement (120; 608, 610) du premier dispositif comprend en outre un support de circuit imprimé (610) pour les composants électriques (614, 620) situés sur ladite surface dudit moyen de recouvrement (120, 608, 610).
